Europäisches Patentamt

European Patent Office

Office européen des brevets

(11) Veröffentlichungsnummer: **0 256 350**
**A1**

(12) **EUROPÄISCHE PATENTANMELDUNG**

(21) Anmeldenummer: 87110719.9

(51) Int. Cl.4: **H05K 9/00**

(22) Anmeldetag: 24.07.87

(30) Priorität: 05.08.86 DE 3626460

(43) Veröffentlichungstag der Anmeldung:
24.02.88 Patentblatt 88/08

(84) Benannte Vertragsstaaten:
**AT BE CH DE ES FR GB IT LI NL SE**

(71) Anmelder: **Lehmann & Voss & Co.**
**Alsterufer 19**
**D-2000 Hamburg 36(DE)**

(72) Erfinder: **Petermann, Hans Jürgen,**
**Prof.Dr.rer.nat.**
**Westpreussenweg 12**
**D-2150 Buxtehude(DE)**
Erfinder: **Wenderoth, Klaus, Dipl.-Ing.**
**Schweriner Strasse 1b**
**D-2150 Buxtehude(DE)**
Erfinder: **Krieger, Wolfram H. O., Dr,rer.nat.**
**Salomon-Heine-Weg 48A**
**D-2000 Hamburg 20(DE)**

(74) Vertreter: **UEXKÜLL & STOLBERG**
**Patentanwälte**
**Beselerstrasse 4**
**D-2000 Hamburg 52(DE)**

(54) **Kunststoffmischung mit elektromagnetischen Abschirmeigenschaften.**

(57) Die Erfindung betrifft eine Kunststoffmischung mit elektromagnetischen Abschirmeigenschaften auf Basis einer Matrix mit einem Gehalt an Ferroelektrika und elektrisch leitfähigen und/oder ferromagnetischen Füllstoffen, die dadurch gekennzeichnet ist, daß die ferroelektrische Komponente einen Curie-Punkt bzw. einen den Curie-Punkt einschließenden Phasenumwandlungsbereich von der ferroelektrischen in die paraelektrische Phase aufweist, der im Bereich der Einsatztemperatur von -40 bis +98°C des elektromagnetischen Abschirmmaterials liegt und, bezogen auf das Volumen des elektromagnetischen Materials, in einer Menge von 1 bis 20 Vol.% vorliegt, während die elektrisch leitfähigen bzw. ferromagnetischen Füllstoffe in Mengen von 5 bis 15 Vol.% vorhanden sind, wobei vorzugsweise die ferroelektrischen Komponenten eine organische Verbindung aus der Gruppe von Semicarbazid-hydrochlorid, Quadratsäure, Triglycinsulfat oder eine anorganische Verbindung aus der Gruppe bestehend aus Barium-Strontiumtitanaten und Antimonjodidsulfid ist.

EP 0 256 350 A1

## KUNSTSTOFFMISCHUNG MIT ELEKTROMAGNETISCHEN ABSCHIRMEIGENSCHAFTEN

Die Erfindung betrifft eine Kunststoffmischung mit elektromagnetischen Abschirmeigenschaften auf Basis einer Kunststoffmatrix mit einem Gehalt an Ferroelektrika und elektrisch leitfähigen und/oder ferromagnetischen Füllstoffen.

Elektromagnetisches Abschirmmaterial auf Basis von Kunststoffen wird beispielsweise bei Gehäusen von elektronischen Geräten verwendet, um den Durchtritt unerwünschter elektromagnetischer Wellen zu verhindern, die als Störquelle wirken.

Aus der EU-A-1 0043 040 sind Verbundmaterialien zur Abschirmung elektromagnetischer Strahlung bekannt, die in einer Polymermatrix metallisierte textile Flächengebilde, Fäden oder metallisierte Teilchen enthalten, wobei als Matrixmaterial ein polymerer Kunststoff wie beispielsweise ein weichgestelltes Polyvinylchlorid vorgesehen ist. Metallisierte Gewebe lassen sich jedoch in eine Kunststoffmatrix nur mit Schwierigkeiten einarbeiten und schon gar nicht als Granulat auf übliche Weise durch Extrudieren oder Spritzen verarbeiten. Metallisierte Fäden lassen sich in einer Kunststoffmatrix bei Extrusion oder Spritzen nur schlecht verteilen, wodurch für die elektromagnetische Strahlung durchlässige "Fenster" entstehen. Diese Massen enthalten neben der elektrisch leitenden Komponente noch Additive zur Erhöhung der elektrischen und/oder magnetischen Leitfähigkeit wie Ruß, Graphit oder Ferrite. Ihre Abschirmung ist bei metallisierten Fäden enthaltenden Massen gering und liegt in einem Bereich von 38 bis 29 dB bei einem Frequenzbereich von 50 MHz bis 35 GHz.

Aus der DE-OS 35 18 335 ist ferner ein elektromagnetisches Abschirmmaterial bekannt, welches in einer hochmolekularen organischen Matrix wie Gummi, Thermoplast oder Kunstharz ein elektrisch leitfähiges Kohlenstoffpulver und ein Mn-Zn-Ferritpulver enthält. Die Abschirmungsfähigkeit dieses Materials reicht allerdings nur bis 45 dB bei einer Standardfrequenz von 1000 MHz. Außerdem sind die erforderlichen Füllmengen an Ferriten mit 30 - 70 Vol.% so groß, daß eine Beeinträchtigung der mechanischen Eigenschaften der Kunststoffmassen erfolgt.

Letztlich ist aus der EU-A-20-0 90 432 ein elektromagnetisches Abschirmmaterial bekannt, bei dem in einer Kunststoffmatrix kurze Metallfäden mit hoher elektrischer Leitfähigkeit und eine ferromagnetische Komponente vorhanden sind. Die leitfähigen Metallfäden können aus Edelmetallen, Kupfer, Aluminium, Zink, Nickel, Eisen und deren Legierungen bestehen, während das ferromagnetische Material aus Ferritten, Eisen, Kobalt und Nickel besteht; ferner kann neben Ruß noch eine ferroelektrische Komponente vorhanden sein, wie Bariumtitanat, Bleititanat, Bleiniobat und Bleizirkonat. Auch diese Abschirmmassen haben den Nachteil, daß sie wegen der Metallfäden schlecht verarbeitbar sind; im übrigen ist die Abschirmung, die bei 8 bis 13 GHz im Bereich von 10 bis 20 dB liegt, unzureichend.

Die Erfindung hat sich die Aufgabe gestellt, ein elektromagnetisches Abschirmmaterial vorzuschlagen, welches sowohl hinsichtlich der Verarbeitungsfähigkeit einfach nach den üblichen Verfahren, insbesondere der Kunststoffextrusions-und -spritztechnik einsetzbar ist, als auch keine für elektromagnetische Wellen durchlässigen "Fenster" zeigt und eine äußerst hohe Abschirmung ermöglicht.

Zur Lösung dieser Aufgabe wird daher ein Abschirmmaterial gemäß Hauptanspruch vorgeschlagen, wobei besonders bevorzugte Ausführungsformen in den Unteransprüchen erwähnt sind.

Überraschenderweise hat sich gezeigt, daß bei derartigen Abschirmmaterialien gemäß Erfindung, die elektrisch leitfähige und/oder ferromagnetische Füllstoffe enthalten, die Art der ebenfalls vorhandenen Ferroelektrika eine erhebliche Rolle spielt. Erstaunlicherweise hat sich nämlich erwiesen, daß solche Ferroelektrika in derartig aufgebauten elektromagnetischen Abschirmmaterialien bei den wesentlichen Standardfrequenzen von z.B. 30 MHz bis 30 GHz eine besonders gute Abschirmung zeigen, bei denen die Ferroelektrika einen Curie-Punkt haben, der im Bereich der betreffenden Einsatztemperatur des Abschirmmaterials liegt, wobei anstelle des Curie-Punktes auch der diesen Curie-Punkt einschließende Phasenumwandlungsbereich von der ferroelektrischen in die paraelektrische Phase dem Curie-Punkt gleichzusetzen ist. Der Curie-Punkt kann nämlich einmal als eine ganz bestimmte Temperatur definiert werden, bei der sich die als Ferroelektrikum einzusetzende ferroelektrische Verbindung von der einen Phase in die andere umwandelt; zum anderen kann anstelle des Curie-Punktes jedoch auch ein Temperaturbereich als Phasenumwandlungsbereich angesehen werden, der den Curie-Punkt einschließt, und den Temperaturbereich der Umwandlung von der ferroelektrischen in die paraelektrische Phase umfaßt.

Gemäß Erfindung sollen die Ferroelektrika mit den erfindungsgemäß bei der Einsatztemperatur liegenden Curie-Punkten bzw. Phasenumwandlungsbereichen in einer Menge von 1 bis 20 Vol.% im Abschirmmaterial vorhanden sein, während die leitfähigen Füllstoffe in Mengen von 5 bis 15 Vol.% vorhanden sein sollen.

Die Bezugsgröße auf den Volumenanteil der Ferroelektrika, bezogen auf das Gesamtvolumen des elektromagnetischen Abschirmmaterials, ist deswegen vorzuziehen, weil die den erfindungsgemäßen Anforderungen entsprechenden Ferroelektrika in ihrer spezifischen Dichte erheblich voneinander abweichen; so haben beispielsweise die bevorzugt eingesetzten organischen Ferroelektrika wie Semicarbazid-hydrochlorid, Quadratsäure bzw. 3,4-Dihydroxy-3-cyclobuten-1,2-dion und Triglycinsulfat eine verhältnismäßig geringe Dichte von 1,58, bzw. von etwa 1,2 und von 1,69 $g/cm^3$, während anorganische Ferroelektrika wie Barium-strontiumtitanat oder Antimonjodidsulfid, SbJS, ein verhältnismäßig schweres spezifisches Gewicht von 6 bis 8 $g/cm^3$ haben.

Wenngleich die theoretischen Zusammenhänge noch nicht völlig geklärt sind, kann doch angenommen werden, daß die erfindungsgemäßen Ferroelektrika mit einem Curie-Punkt oder einem Phasenumwandlungsbereich im Bereich der Einsatztemperatur deswegen eine besonders wirkungsvolle Abschirmung ergeben, weil die elektromagnetische Strahlung, die bei der Arbeitsoder Einsatztemperatur des Abschirmmaterials auf dieses trifft, gerade im Bereich der Curietemperatur einen übermäßig hohen Energieanteil an der einstrahlenden oder ausstrahlenden elektromagnetischen Wellenenergie absorbiert.

Die Curietemperaturen $T_c°C$ der erfindungsgemäß zu verwendenden Ferroelektrika sowie der bislang eingesetzten ferroelektrischen Verbindungen ergeben sich aus der folgenden Tabelle I.

## Tabelle I

| Ferroelektrische Verbindung | $T_c\,°C$ |
| --- | --- |
| Semicarbazid-Hydrochlorid | $21°C$ |
| Quadratsäure | $98°C$ |
| Triglycinsulfat | $49°C$ |
| $Ba_{0,8}Sr_{0,2}TiO_3$ | $70°C$ |
| $Ba_{0,7}Sr_{0,2}TiO_3$ | ca. $20°C$ |
| Antimonjodidsulfid, SbJS | |
| Bariumtitanat | $135°C$ |
| Bleititanat | $490°C$ |
| Strontiumtitanat | $-163°C$ |
| Bleiniobat | $570°C$ |
| Bleizirkonat | $230°C$ |

Die Matrix kann aus üblichen Gießharzen, Thermoplasten, Duroplasten oder Elastomeren oder anderen Trägermaterialien bestehen. Die Kunststoffmatrices können als Folie oder fester Körper aber auch als Dispersion z.B. für Lacke vorliegen.

Die Teilchengröße der einzelnen Bestandteile in dem Trägermaterial richtet sich in erster Linie nach dem Einsatzzweck und nach der Verarbeitbarkeit. Im allgemeinen liegt die Teilchengröße der elektrisch leitfähigen bzw. ferromagnetischen Füllstoffe in einem Bereich von 1 μm bis 800 μm und vorzugsweise in einem Bereich von 1 μm bis 100 μm und für Ruß bis herab zu 30 nm, während die Ferroelektrika vorzugsweise ebenfalls in einer feinteiligen Form vorliegen sollen und eine Teilchengröße von beispielsweise 1 bis 500 μm und vorzugsweise von 1 bis 20 μm.

Im folgenden soll die Erfindung anhand von Beispielen näher erläutert werden.

**Beispiel 1**

Es wurden elektromagnetische Abschirmmaterialien mit einer Polypropylenmatrix hergestellt, die als elektrisch leitenden und ferromagnetischen Füllstoff Nickel in einer Teilchengröße von 2,5 $\mu$m enthielten und zusätzlich als Ferroelektrika einmal Semicarbazid-hydrochlorid oder Triglycinsulfat oder Barium-strontiumtitanat der Formel $Ba_{0,8}Sr_{0,2}.TiO_3$ enthielten.

Es wurden Abschirmungsmessungen mit einer Meßanordnung nach Prof. ter Haseborg modifizierten (R.M. Simon "High accuracy in EMI measurament", Mod. Pl. Int. 9, 124 (1983)) bestimmt, bei der die Proben der Kunststoffmischungen mit einem Durchmesser von 10 cm und einer Dicke von 0,3 cm in eine Meßkammer zwischen Sender und Empfänger (Antennen) eingebracht wurden. Die Messungen wurden bei Frequenzen von 1 MHz bis 1 GHz durchgeführt.

Es wurde einmal die Abschirmung in dB in Abhängigkeit von der Frequenz an einem System von Polypropylen und Nickel mit steigenden Mengen von 0 Vol.%, 5 Vol.%, 10 Vol.%, 15 Vol.% und 20 Vol.% Nickel bestimmt; in einem weiteren Versuch wurde das System Polypropylen und 10 Vol.% Nickel mit einem Zusatz von 5 Vol.% Semicarbazid-hydrochlorid (SHCl) und 10 % Semicarbazid-hydrochlorid oder 10 Vol.% Triglycinsulfat (TgS) gemessen, wobei die folgenden Werte bei einer Standardfrequenz von 500 MHz gemäß folgender Tabelle II erhalten wurden:

### Tabelle II

#### Abschirmung in dB bei 500 MHz bei

|  | 0% Ni | 5% Ni | 10% Ni | 15% Ni | 20% Ni |
|---|---|---|---|---|---|
| ohne Ferroelektrika | – | 5 | 23 | 75 | 75 |
| + 5 Vol.% SHCl | – | – | 75 | – | – |
| +10 Vol.% SHCl | 12 | – | >75 | – | – |
| + 10 Vol.% TgS | – | – | 55 | – | – |
| + 10 Vol.% $Ba_{0,8}Sr_{0,2}TiO_3$ | – | – | 35 | – | – |

Die obigen Werte zeigen, daß durch Zusatz von nur 5 bis 10 Vol.% Semicarbazid-hydrochlorid die gleichen Abschirmwerte erreicht werden wie bei einem sehr viel höheren Ni-Zuatz von 15 bis 20 Vol.%, der die Verarbeitbarkeit der Kunststoffmischungen erheblich erschweren und auch verteuern würde. Die Werte zeigen ferner, daß bei Barium-Strontium-Titanat eine starke Abschirmung von 35 dB bei 500 MHz gegeben war, die jedoch geringer als die mit Semicarbazidhydrochlorid war. Dieses ist auch verständlich, da die Curietemperatur und somit der starke Anstieg der Dielektrizitätskonstanten von Barium-Strontium-titanat von 70°C im Gegensatz zum Semicarbazid-hydrochlorid von 21°C zu höheren Arbeitstemperaturen verschoben ist.

**Beispiel 2**

Es wurde analog Beispiel 1 Kunststoffmischungen auf Basis von Polypropylen hergestellt, die jeweils 10 Vol.% Ni und die erfindungsgemäßen Ferroelektrika in verschiedenen Konzentrationen enthielten.

Die folgende Tabelle III zeigt mit Nickel leitfähig gemachte Polypropylen-Zusammensetzungen, die Ferroelektrika mit unterschiedlichen Curietemperaturen $T_E$ enthalten. Die Schirmdämpfung wurde bei verschiedenen Einsatztemperaturen gemessen. Bei Triglycinsulfat und Semicarbazid-hydrochlorid zeigt sich, daß die Schirmdämpfung dann am größten ist, wenn die Meßtemperatur in der Nähe der Curietemperatur liegt.

0 256 350

## Tabelle III

### Schirmdämpfung von PP-Mischungen bei unterschiedlichen Meßtemperaturen

| Versuch | Zusammensetzung in Vol.% | $T_E$ $^\circ$C | Schirmdämpfung bei 1 GHz dB | Curie-Temp. $^\circ$C |
|---|---|---|---|---|
| Nr. 1 | Triglycinsulfat | 28 | 37 | 49 |
| | 10% Ni + | 45 | 40 | |
| | 10% TgS | 90 | 25 | |
| | Probe 2 mm | | | |
| Nr. 2 | Semicarbazid-hydrochlorid | 25 | 80 | |
| | 10% Ni + | 45 | 75 | 21 |
| | 5% SHCl | 90 | 47 | |
| Nr. 3 | Semicarbazid-hydrochlorid | 25 | 75 | |
| | 10% Ni + | 45 | 30 | 21 |
| | 10% SHCl | 90 | 10 | |

TgS  = Triglycinsulfat

SHCl = Semicarbazid-hydrochlorid

Die Werte der obigen Tabelle zeigen deutlich, daß die erfindungsgemäß ausgewählten Ferroelektrika bei den entsprechenden Einsatztemperaturen $T_E$ mit ihren entsprechenden $T_E$-Werten im Bereich der Curietemperatur, bei der Schirmdämpfung die besten Werte zeigen; und zwar bei Versuch Nr. 1 mit einer Curietemperatur von 49°C bei $T_E$ = 45°C; bei Versuch Nr. 2 und Nr. 3 mit einer Curietemperatur von 21°C bei $T_E$-Werten von 25°C.

5

## Vergleichsversuch

Es wurde eine metallisierte Abschirmmasse analog EU-A-2 0090 432 mit einem ferromagnetischen Material nämlich Nickel mit einer Teilchengröße von 2,5 µm in einer Menge von 10 Vol.% und Bariumtitanat als Ferroelektrikum in einer Menge von 10 Vol.% untersucht. Die Abschirmergebnisse waren kaum besser als für eine reine 10 Vol.% Ni-Füllung und lagen nur bei 23 dB, was dadurch zu erklären ist, daß Bariumtitanat bereits eine Curietemperatur von 135°C hat, während die Barium-Strontium-titanat-Umwandlungstemperatur bei 70°C liegt, also sehr viel besser für den Einsatzbereich des Abschirmmaterials geeignet ist.

Auch für den bekannten Einsatz von reinem Bleititanat (10 Vol.%) mit Curietemperaturen von 490°C und 10 Vol.% Nickel ergaben sich nur sehr geringe Abschirmungswerte von etwa 10 dB, die sogar niedriger liegen als bei einem alleinigen Einsatz von 10 Vol.% Ni.

## Ansprüche

1. Kunststoffmischung mit elektromagnetischen Abschirmeigenschaften auf Basis einer Matrix mit einem Gehalt an Ferroelektrika und elektrisch leitfähigen und/oder ferromagnetischen Füllstoffen, **dadurch gekennzeichnet**, daß die ferroelektrische Komponente einen Curie-Punkt bzw. einen den Curie-Punkt einschließenden Phasenumwandlungsbereich von der ferroelektrischen in die paraelektrische Phase aufweist, der im Bereich der Einsatztemperatur von -40 bis +98°C des elektromagnetischen Abschirmmaterials liegt und, bezogen auf das Volumen des elektromagnetischen Materials in einer Menge von 1 bis 20 Vol.% vorliegt, während die elektrisch leitfähigen bzw. ferromagnetischen Füllstoffe in Mengen von 5 bis 15 Vol.% vorhanden sind.

2. Kunststoffmischung nach Anspruch 1, **dadurch gekennzeichnet**, daß die ferroelektrische Komponente eine organische Verbindung aus der Gruppe von Semicarbazid-hydrochlorid, Quadratsäure, Triglycinsulfat oder eine anorganische Verbindung aus der Gruppe bestehend aus Barium-Strontiumtitanaten und Antimonjodidsulfid ist.

3. Kunststoffmischung nach Anspruch 1 und 2, **dadurch gekennzeichnet**, daß die elektrisch leitfähigen und ferromagnetischen Füllstoffe Nickel, Eisen oder Kobalt und die nur elektrisch leitenden Füllstoffe Ruß, Kohlenstoffasern oder Fasern oder Flocken aus paramagnetischen oder diamagnetischen Metallen sind.

4. Kunststoffmischung nach Anspruch 1 bis 3, **dadurch gekennzeichnet**, daß die Matrix ein polymeres Trägermaterial auf Basis von Verbindungen der Gruppe der thermoplastischen Kunststoffe, der Elastomeren, der Duroplaste und der Gießharze ist.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| D,A | EP - A3 - 0 090 432 (NEC) <br><br> * Zusammenfassung; Ansprüche 1-12 * <br><br> -- | 1 | H 05 K 9/00 |
| D,A | EP - A1 - 0 043 040 (BAYER) <br><br> * Zusammenfassung; Ansprüche 1-10 * <br><br> -- | 1 | |
| D,A | DE - A1 - 3 518 335 (TDK) <br><br> * Zusammenfassung; Ansprüche 1-9 * <br><br> ---- | 1 | |

EP 87110719.9

RECHERCHIERTE
SACHGEBIETE (Int. Cl.4)

H 05 K 9/C

H 01 F 1/C

H 01 B 1/C

Der vorliegende Recherchenbericht wurde für alle Patentansprüche erstellt.

| Recherchenort | Abschlußdatum der Recherche | Prüfer |
|---|---|---|
| WIEN | 11-11-1987 | VAKIL |